# EUROPÄISCHE PATENTSCHRIFT

(11) **EP 1 737 075 B1**
(45) Veröffentlichungstag und Bekanntmachung des Hinweises auf die Patenterteilung: **08.03.2017**
(21) Anmeldenummer: 06011045.9
(22) Anmeldetag: 30.05.2006
(51) Int. Cl.: H01R 13/03, G01R 3/00, G01R 1/073

(54) **Kontaktiervorrichtung**
Contacting device
Dispositif à contacts

(30) Priorität: 23.06.2005 DE 102005029105; 15.04.2006 DE 102006017758
(43) Veröffentlichungstag der Anmeldung: 27.12.2006
(73) Patentinhaber: Feinmetall GmbH, 71083 Herrenberg (DE)
(72) Erfinder: Schmidt, Rainer, 72124 Pliezhausen (DE); Weiland, Achim, 71157 Hildrizhausen (DE)
(74) Vertreter: Grosse, Rainer

(56) Entgegenhaltungen:
- EP-A- 0 790 502
- WO-A1-99/49329
- DE-A1- 2 904 360
- DE-A1- 3 715 171
- DE-A1- 19 748 825
- JP-A- 2002 311 055
- US-A- 3 044 151
- US-A1- 4 069 370
- US-A1- 4 183 609
- US-A1- 4 294 726
- US-A1- 4 820 170
- US-A1- 4 897 043
- US-A1- 5 097 100
- US-A1- 2004 239 578

## Beschreibung

Die Erfindung betrifft eine Kontaktiervorrichtung zum elektrischen Verbinden eines Prüflings mit einer elektrischen Prüfeinrichtung, mit mehreren, mindestens einem Haltelement zugeordneten elektrischen Prüfkontakten zur Kontaktierung des Prüflings und mit einer Umsetzeinrichtung zur Vergrößerung des Abstandes benachbarter Kontaktwege, wobei die Umsetzeinrichtung Kontaktelemente zur Berührungskontaktierung der Prüfkontakte aufweist.

Eine bekannte Kontaktiervorrichtung der eingangs genannten Art weist einen Prüfkopf auf, der mehrere, im Abstand zueinander angeordnete Halteelemente aufweist, die als Führungsplatten ausgebildet sind und Führungsbohrungen aufweisen, in denen als Knickdrähte ausgebildete Prüfkontakte längsverschieblich einliegen. Die Prüfkontakte stehen mit einer Umsetzeinrichtung in Berührungskontakt, wobei die Umsetzeinrichtung dazu dient, den sehr engen, durch den Kontaktabstand des Prüflings vorgegebenen Kontaktabstand der Prüfkontakte zu vergrößern, so dass benachbarte Kontaktwege einen größeren Abstand voneinander besitzen. Hierzu sind die dem Prüfkopf abgewandten Enden der Kontaktelemente der Umsetzeinrichtung mit einer Leiterplatte verbunden, wobei die Leiterplatte mit einer elektrischen Prüfeinrichtung in Verbindung steht, mit der eine elektrische Prüfung des mit den Prüfkontakten des Prüfkopfs kontaktierten Prüfling vorgenommen wird. Auf diese Art und Weise lassen sich beispielsweise in der Computertechnik einzusetzende Wafer prüfen. Da die Kontaktierung der Prüfkontakte des Prüfkopfes mit den Kontaktelementen der Umsetzeinrichtung durch Aneinanderdrücken erfolgt, liegt eine einwandfreie Kontaktierung nur dann vor, wenn Oxydschichten und Verunreinigungen vermieden werden. Demgemäss werden bei der Umsetzeinrichtung als Kontaktelemente Kupferdrähte eingesetzt, die an ihren Kontaktstellen vergoldet sind. Trotz der Vergoldung kann es durch Umwelteinflüsse oder Wartungsmaßnahmen zu einer nicht optimalen Kontaktierung kommen.

Aus der WO-A1-99/49329 ist eine Prüfeinrichtung bekannt, bei der Prüfkontakte eingesetzt werden, die aus einer Legierung bestehen, die Gold, Platin, Palladium, Silber, Kupfer und Zink enthält. Ferner werden andere Materialien zur Herstellung von Prüfkontakten genannt, die Stoffe wie Gold, Platin und seine Legierungen, rostfreien Stahl, Wolfram und Wolframlegierungen, Nickellegierungen, metallplattierte Laminate, elektrisch leitfähigen Kunststoff sowie elektrisch leitfähige Polymerzusammensetzungen enthalten. Die aus der genannten Literaturstelle hervorgehenden Prüfkontakte wirken mit Kontaktelementen zusammen, deren Material nicht erläutert wird.

Aus der JP-A-2002311055 geht eine Beryllium-Kupfer-Legierung für Kontaktelemente hervor. Beschrieben werden alternativ ferner Kupfer-Silber-Legierungen für Kontaktelemente.

Der Erfindung liegt die Aufgabe zugrunde, eine Kontaktiervorrichtung der eingangs benannten Art zu schaffen, bei der stets eine gute Kontaktierung zwischen den Prüfkontakten und den Kontaktelementen der Umsetzeinrichtung gegeben ist.

Diese Aufgabe wird erfindungsgemäß durch die Merkmale des Anspruchs 1 gelöst. Die Edelmetalllegierung oder die Legierung mit mindestens einem Edelmetallanteil wird derart gewählt, dass insbesondere sehr gute elektrische Eigenschaften vorliegen und vorzugsweise auch bei hohen Temperaturen und/oder hoher Luftfeuchtigkeit die Bildung von Oxydschichten vermieden wird. Die Edelmetalllegierung weist nur Edelmetalle (mindestens zwei) auf. Die Legierung mit mindestens einem Edelmetallanteil weist mindestens einen Edelmetallanteil oder mehrere Edelmetallanteile auf und mindestens einen Nichtedelmetallanteil oder mehrere Nichtedelmetallanteile. Bei dem Nichtedelmetallanteil kann es sich um ein unedles Metall handeln oder einen Stoff, der nicht aus Metall besteht. Gegenüber einer Vergoldung führt der erfindungsgemäße Einsatz von einer massiven Edelmetalllegierung oder einer massiven Legierung mit mindestens einem Edelmetallanteil dazu, dass mit einer Beschichtung zusammenhängende Probleme, wie sie beispielsweise bei einer Goldbeschichtung dann auftreten, wenn diese abrasiv gereinigt wird, um die Kontaktierung zu verbessern, nicht auftreten können. Vielmehr ist aufgrund der massiven Edelmetalllegierungs- oder Legierung-mitmindestens-einem-Edelmetallanteil-Ausbildung auch bei einer Reinigung eine stets gleichbleibende, gute elektrische Kontaktierung gegeben. Bei hohen Temperaturen und/oder hoher Luftfeuchtigkeit sind aufgrund des erfindungsgemäß eingesetzten Materials stets niederohmige Berührungskontakte möglich. Die ausgewählte Edelmetalllegierung und/oder die ausgewählte Legierung mit mindestens einem Edelmetallanteil kann an die unterschiedlichen Temperaturbereiche des jeweiligen Einsatzortes durch entsprechende Materialauswahl angepasst werden. Insbesondere ist es auch möglich, dass die Prüfkontakte des Prüfkopfes aus einer massiven Edelmetalllegierung oder einer massiven Legierung mit mindestens einem Edelmetallanteil bestehen, dass also auch hier keine Beschichtungsprozesse durchgeführt werden. Insbesondere können die Kontaktelemente und die Prüfkontakte aus denselben Materialen bestehen, so dass aufeinander angepasste Verhältnisse vorliegen.

Es ist vorgesehen, dass die Edelmetalllegierung mindestens zwei der folgenden Edelmetalle aufweist: Silber, Gold, Palladium, Platin.

Es ist vorgesehen, dass die Legierung mit mindestens einem Edelmetallanteil als Edelmetallanteil Silber, Gold, Palladium und/oder Platin sowie Nickel und/oder Kohlenstoff aufweist.

Nach einer Weiterbildung der Erfindung ist vorgesehen, dass die Legierung mit mindestens einem Edelmetallanteil eine Silber-Kohlenstoff-Legierung ist, insbesondere AgC1 bis AgC6, vorzugsweise AgC3. Mit C ist Kohlenstoff gekennzeichnet. Hier gibt die Ziffer nach dem mit C angegebenen Kohlenstoff die Gewichtsprozente an (also 1 % bis 6 %, vorzugsweise 3 % Kohlenstoff und der Rest jeweils Silber, ebenso sind entsprechende Angaben in diesem Patent zu lesen).

Eine Weiterbildung der Erfindung sieht vor, dass die Legierung mit mindestens einem Edelmetallanteil eine Gold-Nickel-Legierung ist. Vorzugsweise wird AuNi1 bis AuNi10, vorzugsweise AuNi5 eingesetzt. Mit Au ist Gold gekennzeichnet, mit Ni Nickel. Die Ziffern geben wiederum die Gewichtsprozente an, so bedeutet AuNi5 beispielsweise, dass 5 % Nickel in der Legierung vorhanden sind, die im übrigen aus Gold besteht.

Es ist ferner vorteilhaft, wenn die Edelmetalllegierung eine Gold-Palladium-Legierung ist, insbesondere AgPd10 bis AgPd60, vorzugsweise AgPd40. Mit Pd ist Palladium gekennzeichnet und die Ziffern geben wiederum die Gewichtsprozente an.

Die Kontaktelemente können insbesondere als Kontaktdrähte ausgebildet sein, die massiv aus einer Edelmetalllegierung oder massiv aus einer Legierung mit mindestens einem Edelmetallanteil bestehen.

Eine Weiterbildung der Erfindung sieht vor, dass die Kontaktdrähte in Durchbrüchen der Umsetzeinrichtung mit ihren Enden einliegen oder diese Durchbrüche durchgreifen. Eine derartige Umsetzeinrichtung wird üblicherweise auch als "Interface" oder "Connector" bezeichnet. Die Umsetzeinrichtung weist demgemäss ein Halteglied auf, dass von dem erwähnten Durchbrüchen durchsetzt ist, wobei das Kontaktmuster der Durchbrüche dem Kontaktmuster der Prüfkontakte des Prüfkopfs entspricht. In den Durchbrüchen sind die Kontaktelemente derart angeordnet, dass sie mit Kontaktflächen den als Prüfstifte oder Knickdrähte ausgebildeten Prüfkontakten gegenüberliegen. Um die Kontaktelemente am Halteglied zu befestigen, sind die Kontaktelemente, insbesondere Kontaktdrähte, durch Vergießen in den Durchbrüchen befestigt. Sofern die Kontaktelemente als Kontaktdrähte ausgebildet sind, ist es möglich, dass sie aus der dem Prüfkopf abgewandten Seite der Umsetzeinrichtung herausschauen und mit einer Anschlusseinrichtung verbunden sind, die insbesondere als Leiterplatte (PCB) ausgebildet sein kann. Insbesondere ist vorgesehen, dass die entsprechenden Enden der Kontaktdrähte mit Leiterbahnen der Leiterplatte elektrisch verbunden sind. Die Anschlusseinrichtung steht mit der elektrischen Prüfeinrichtung in Verbindung oder ist ein Teil der elektrischen Prüfeinrichtung.

Nach einer Weiterbildung der Erfindung ist vorgesehen, dass die Edelmetalllegierung oder die Legierung mit mindestens einem Edelmetallanteil eine getemperte Edelmetalllegierung oder eine getemperte Legierung ist. Demzufolge wird die Edelmetalllegierung getempert, also einer Wärmebehandlung unterzogen. Gleiches gilt für die Legierung mit mindestens einem Edelmetallanteil. Auf diese Art und Weise werden die elektrischen Eigenschaften, insbesondere die Widerstandswerte des Kontaktelements besonders günstig beeinflusst, sodass vorzugsweise eine möglichst niederohmige Verbindung geschaffen werden kann und/oder vorzugsweise ein konstanter Widerstandswert über einen weiten Temperaturbereich vorliegt.

Es ist vorzugsweise vorgesehen, dass die Edelmetalllegierung oder die Legierung mit mindestens einem Edelmetallanteil eine mindestens 30 Minuten, insbesondere 60 Minuten, getemperte Edelmetalllegierung oder Legierung ist. Demzufolge erfolgt der Tempervorgang zeitgesteuert, das heißt, die Erwärmung auf die Tempertemperatur erfolgt innerhalb eines bestimmten, vorgegebenen Zeitrahmens, der mindestens 30 Minuten, insbesondere mindestens 60 Minuten, beträgt, sodass eine hinreichend lange Zeitspanne vergeht, bis die gewünschte Tempertemperatur erreicht ist. Alternativ erfolgt der Tempervorgang bei einer vorgegebenen Tempertemperatur in mindestens 30 Minuten, vorzugsweise mindestens 60 Minuten.

Ferner ist es vorteilhaft, wenn die Edelmetalllegierung oder die Legierung mit mindestens einem Edelmetallanteil nach dem Temperprozess, insbesondere direkt nach dem Temperprozess, über einen vorbestimmten Zeitraum auf Raumtemperatur abgekühlt wird. Der Zeitraum beträgt insbesondere mindestens 15 Minuten, vorzugsweise mindestens 30 Minuten. Demzufolge wird im Anschluss an den Temperprozess eine kontrollierte Abkühlung vorgenommen, die mindestens einen Zeitraum von 15 Minuten, vorzugsweise mindestens 30 Minuten beträgt. Hierbei wird bevorzugt bis auf Raumtemperatur abgekühlt. Auch dieses kontrollierte Abkühlen sorgt dafür, dass die vorstehend erwähnten elektrischen Eigenschaften beim Kontaktelement erzielt werden.

Die Erfindung betrifft ferner ein Verfahren zum Herstellen mindestens eines Kontaktelements einer derartigen Kontaktiervorrichtung zum elektrischen Verbinden eines Prüflings mit einer elektrischen Prüfeinrichtung, mit mehreren, mindestens einem Halteelement zugeordneten elektrischen Prüfkontakten zur Kontaktierung des Prüflings und mit einer Umsetzeinrichtung zur Vergrößerung des Abstandes benachbarter Kontaktwege, wobei die Umsetzeinrichtung Kontaktelemente zur Berührungskontaktierung der Prüfkontakte aufweist, wobei jedes der Kontaktelemente aus einer Edelmetalllegierung oder aus einer Legierung mit mindestens einem Edelmetallanteil gemäß Anspruch 13 gefertigt wird.

Vorzugsweise ist verfahrensmäßig vorgesehen, dass die Edelmetalllegierung oder die Legierung mit mindestens einem Edelmetallanteil mindestens 30 Minuten, vorzugsweise mindestens 60 Minuten, getempert wird.

Vorteilhaft ist es, wenn das Tempern bis auf eine Temperatur von 80°C bis 160°C, vorzugsweise bis auf eine Temperatur von 120°C erfolgt oder bei einer Temperatur von 80°C bis 160°C, vorzugsweise bei einer Temperatur von 120°C durchgeführt wird.

Nach dem Tempern, insbesondere unmittelbar nach dem Tempern, erfolgt vorzugsweise eine Abkühlung über einen Zeitraum von mindestens 15 Minuten, vorzugsweise mindestens 30 Minuten.

Schließlich ist es vorteilhaft, wenn die Abkühlung bis auf Raumtemperatur, insbesondere bis auf eine Temperatur von 15°C bis 25°C, vorzugsweise bis auf eine Temperatur von 20°C, erfolgt.

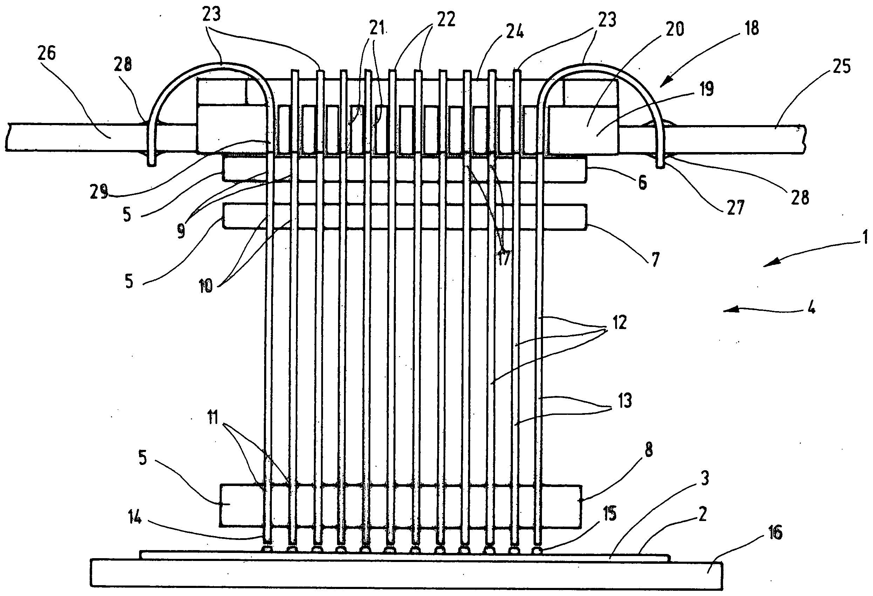

Die Zeichnung veranschaulicht die Erfindung anhand eines Ausführungsbeispiels, das eine Seitenansicht einer Kontaktiervorrichtung zeigt.

Die Figur zeigt eine Kontaktiervorrichtung 1, mit der beispielsweise ein als Wafer 2 ausgebildeter Prüfling 3 zur Prüfung kontaktiert wird. Die Kontaktiervorrichtung 1 steht hierzu mit einer nicht dargestellten elektrischen Prüfeinrichtung in Verbindung, die über eine Vielzahl von Kontaktwegen die einwandfreie Funktion des Prüflings prüft und bei Funktionsfehlern den Prüfling als defekt meldet.

Die Kontaktiervorrichtung 1 weist einen Prüfkopf 4 auf, der mehrere, beispielsweise 3 parallel zueinander mit Abstand liegende Halteelemente 5 aufweist, die als Führungsplatten 6, 7 und 8 ausgebildet sind. Die Führungsplatten 6, 7, 8 verlaufen parallel zueinander. Sie sind von Führungsbohrungen 9, 10 und 11 durchsetzt, die miteinander fluchten oder auch leicht versetzt zueinander liegen können. In den Führungsbohrungen 9 bis 11 sind Prüfkontakte 12 angeordnet, vorzugsweise eingesteckt, so dass sie axial verschieblich gelagert sind. Bei nichtfluchtenden Führungsbohrungen 9 bis 11, beispielsweise bei einer Fluchtung der Führungsbohrungen 9 und 11 und einer hierzu nicht vorliegenden Fluchtung der Führungsbohrungen 10, werden die insbesondere als Knickdrähte 13 ausgebildeten Prüfkontakte 12 leicht seitlich ausgelenkt, so dass sie einerseits nicht aus dem Prüfkopf 4 herausfallen können und andererseits eine Vorzugsrichtung beim Ausknicken erhalten, wenn sie zur Kontaktierung des Prüflings 3 axial belastet werden.

Die dem Prüfling 3 zugewandten Enden 14 der Prüfkontakte 12 stehen Prüflingskontakten 15 gegenüber, wobei sich der Prüfling 3 auf einer Unterlage 16 befindet, insbesondere abstützt.

Den gegenüberliegenden Enden 17 der Prüfkontakte 12 liegt eine Umsetzeinrichtung 18 gegenüber, die ein Halteglied 19 in Form einer Halteplatte 20 aufweist. Die Halteplatte 20 wird von Durchbrüchen 21 durchsetzt, die fluchtend zu den Führungsbohrungen 9 der Führungsplatte 6 angeordnet sind. In den Durchbrüchen 21 befinden sich Kontaktelemente 22, die als Kontaktdrähte 23 ausgebildet sind. Zur Befestigung der Kontaktdrähte 23 in den Durchbrüchen 21 sind diese durch Vergießen mittels einer ausgehärteten Vergussmasse 24 axial und unverschiebbar gehalten. Die Kontaktdrähte 23 führen bogenförmig (180° Bögen) zur einer Anschlusseinrichtung 25, die als Leiterplatte 26 ausgebildet ist. Die Enden 27 der Kontaktdrähte 23 sind mit Leiterbahnen 28 der Leiterplatte 26 verlötet.

Die massiven Kontaktelemente 22, die bevorzugt als massive Kontaktdrähte 23 ausgebildet sind, bestehen aus einer Edelmetalllegierung, die zwei der folgenden Edelmetalle aufweist: Silber, Gold, Palladium, Platin. Als weitere Möglichkeit bestehen die Kontaktelemente aus einer Legierung mit mindestens einem Edelmetallanteil der Edelmetalle Silber, Gold, Palladium und/oder Platin, hinzu kommt mindestens ein weiterer Stoff, der kein Edelmetall ist. Als weiterer Stoff kommt Nickel und/oder Kohlenstoff zum Einsatz.

Für eine Prüfung des Prüflings 3 werden Kontaktiervorrichtung 1 und Prüfling 3 aufeinander zu bewegt, so dass die Enden 14 der Knickdrähte 13 auf die Prüflingskontakte 15 aufsetzen. Ferner treten die Enden 17 der Prüfkontakte 12, insbesondere Knickdrähte 13, und die entsprechend gegenüberliegenden Enden 29 der massiv aus einer Edelmetalllegierung oder alternativ massiv aus einer Legierung mit mindestens einem Edelmetallanteil bestehenden Kontaktelemente 22, insbesondere Kontaktdrähte 23, gegeneinander, so dass auch hier Berührungskontakte gebildet werden. Auf diese Art und Weise wird der Prüfling 3 über die Prüfkontakte 12 des Prüfkopfs 4 mit den Kontaktelementen 22 der Umsetzeinrichtung 18 verbunden, wobei die mit den Kontaktelementen 22 verbundenen Leiterbahnen 28 der Umsetzeinrichtung 18 zu einer nicht dargestellten Prüfeinrichtung führen, die über die einzelnen Stromwege den Prüfling 3 elektrisch auf Funktion prüft.

Vorzugsweise ist vorgesehen, dass die Kontaktelemente 22 möglichst günstige Eigenschaften aufweisen, um bestimmte Anwendungen durchführen zu können. So kann bei einer Anwendung eine sehr niederohmige Verbindung notwendig sein, die jedoch nur in einem sehr engen Temperaturbereich vorliegt, beispielsweise im Bereich der Raumtemperatur. Andere Anwendungen erfordern es, über einen weiten Temperaturbereich einen möglichst konstanten Widerstandswert bei dem jeweiligen Kontaktelement 22 einzuhalten. Hier wird ein Material, insbesondere eine Legierung benötigt, die einen niedrigen Temperaturkoeffizienten des elektrischen Widerstands besitzt. Die in dieser Anmeldung aufgezeigten Materialien haben ferner eine nur geringe Neigung zur Oxidation.

Für Verbindungen mit einem möglichst konstanten Widerstandswert über einen weiten Temperaturbereich, von zum Beispiel -50°C bis +150°C, eignen sich Materialien mit einem Nickelanteil zur Ausbildung der Kontaktelemente 22, bei denen der Temperaturkoeffizient des elektrischen Widerstands (K⁻¹ · 10⁻⁴) < 4 ist. Vor allem sind geeignet: AuNi5, AgPd40.

Um die vorstehend genannten elektrischen Eigenschaften zu erreichen, müssen die Materialien mindestens 60 Minuten bei 120°C getempert werden und anschließend über einen Zeitraum von mindestens 30 Minuten auf Raumtemperatur abkühlen.

Die erfindungsgemäßen Kontaktelemente 22 werden bevorzugt als gezogene Drähte ausgebildet, die vorzugsweise mit einer elektrischen Isolierung versehen werden.

## Patentansprüche

1. Kontaktiervorrichtung (1) zum elektrischen Verbinden eines Prüflings (3) mit einer elektrischen Prüfeinrichtung, mit mehreren, mindestens einem Halteelement (5) zugeordneten elektrischen Prüfkontakten (12) zur Kontaktierung des Prüflings (3) und mit einer Umsetzeinrichtung (18) zur Vergrößerung des Abstandes benachbarter Kontaktwege, wobei die Umsetzeinrichtung (18) Kontaktelemente (22) zur Berührungskontaktierung der Prüfkontakte (12) aufweist, **dadurch gekennzeichnet, dass** die Kontaktelemente (22) aus einer Edelmetalllegierung oder einer Legierung mit mindestens einem Edelmetallanteil bestehen, wobei die Edelmetalllegierung mindestens zwei der folgenden Edelmetalle aufweist: Silber, Gold, Palladium, Platin oder die Legierung mit mindestens einem Edelmetallanteil als Edelmetallanteil Silber, Gold, Palladium und/oder Platin sowie Nickel und/oder Kohlenstoff aufweist.

2. Kontaktiervorrichtung nach Anspruch 1, **dadurch gekennzeichnet, dass** die Legierung mit mindestens einem Edelmetallanteil eine Silber-Kohlenstoff-Legierung ist, insbesondere AgC1 bis AgC6, vorzugsweise AgC3.

3. Kontaktiervorrichtung nach Anspruch 1, **dadurch gekennzeichnet, dass** die Legierung mit mindestens einem Edelmetallanteil eine Gold-Nickel-Legierung ist, insbesondere AuNi1 bis AuNi10, vorzugsweise AuNi5.

4. Kontaktiervorrichtung nach Anspruch 1, **dadurch gekennzeichnet, dass** die Edelmetalllegierung eine Gold-Palladium-Legierung ist, insbesondere AgPd10 bis AgPd60, vorzugsweise AgPd40.

5. Kontaktiervorrichtung nach einem der vorhergehenden Ansprüche, **dadurch gekennzeichnet, dass** die Kontaktelemente (22) Kontaktdrähte (23) sind.

6. Kontaktiervorrichtung nach Anspruch 5, **dadurch gekennzeichnet, dass** die Kontaktdrähte (23) Durchbrüche (21) der Umsetzeinrichtung (18) durchgreifen oder in ihnen einliegen.

7. Kontaktiervorrichtung nach einem der vorhergehenden Ansprüche 5 oder 6, **dadurch gekennzeichnet, dass** die Kontaktdrähte (23) an der Umsetzeinrichtung (18) durch Vergießen befestigt sind.

8. Kontaktiervorrichtung nach einem der vorhergehenden Ansprüche, **dadurch gekennzeichnet, dass** die den Prüfkontakten (12) abgewandten Enden der Kontaktelemente (22) mit Leiterbahnen (28) einer Leiterplatte (PCB) (26) elektrisch verbunden sind.

9. Kontaktiervorrichtung nach einem der vorhergehenden Ansprüche, **dadurch gekennzeichnet, dass** die Edelmetalllegierung oder die Legierung mit mindestens einem Edelmetallanteil eine getemperte Edelmetalllegierung oder eine getemperte Legierung mit mindestens einem Edelmetallanteil ist.

10. Kontaktiervorrichtung nach Anspruch 9, **dadurch gekennzeichnet, dass** die Edelmetalllegierung oder die Legierung mit mindestens einem Edelmetallanteil eine mindestens 30 Minuten, insbesondere mindestens 60 Minuten, getemperte Edelmetalllegierung oder Legierung mit mindestens einem Edelmetallanteil ist.

11. Kontaktiervorrichtung nach einem der vorhergehenden Ansprüche 9 oder 10, **dadurch gekennzeichnet, dass** die Edelmetalllegierung oder die Legierung mit mindestens einem Edelmetallanteil nach dem Temperprozess über einen vorbestimmten Zeitraum auf Raumtemperatur abgekühlt wird.

12. Kontaktiervorrichtung nach Anspruch 11, **dadurch gekennzeichnet, dass** der Zeitraum des Abkühlens mindestens 15 Minuten, vorzugsweise mindestens 30 Minuten, beträgt.

13. Verfahren zum Herstellen mindestens eines Kontaktelements einer Kontaktiervorrichtung nach einem oder mehreren der vorhergehenden Ansprüche zum elektrischen Verbinden eines Prüflings mit einer elektrischen Prüfeinrichtung, wobei die Kontaktelemente (22) aus einer Edelmetalllegierung oder einer Legierung mit mindestens einem Edelmetallanteil gefertigt werden, wobei die Edelmetalllegierung mindestens zwei der folgenden Edelmetalle aufweist: Silber, Gold, Palladium, Platin oder die Legierung mit mindestens einem Edelmetallanteil als Edelmetallanteil Silber, Gold, Palladium und/oder Platin sowie Nickel und/oder Kohlenstoff aufweist.

14. Verfahren nach Anspruch 13, **dadurch gekennzeichnet, dass** die Edelmetalllegierung oder die Legierung mit mindestens einem Edelmetallanteil mindestens 30 Minuten, vorzugsweise mindestens 60 Minuten, getempert wird.

15. Verfahren nach Anspruch 14, **dadurch gekennzeichnet, dass** das Tempern bei einer Temperatur von 80°C bis 160°C, vorzugsweise bei 120°C erfolgt.

16. Verfahren nach einem der vorhergehenden Ansprüche 14 oder 15, **dadurch gekennzeichnet, dass** nach dem Tempern eine Abkühlung über einen Zeitraum von mindestens 15 Minuten, insbesondere mindestens 30 Minuten, erfolgt.

17. Verfahren nach Anspruch 16, **dadurch gekennzeichnet, dass** die Abkühlung auf Raumtemperatur, insbesondere auf 15°C bis 25°C, vorzugsweise 20°C, erfolgt.

## Claims

1. A contacting apparatus (1) for electrically connecting a unit under test (3) to an electrical test device, with multiple electrical test contacts (12) for contacting the unit under test (3) assigned to at least one holding element (5), and with a transfer device (18) for increasing the distance between adjacent contact paths, wherein the transfer device (18) comprises contact elements (22) for touch contacting the test contacts (12), **characterized in that** the contact elements (22) consist of a noble metal alloy or of an alloy with at least one noble metal content, wherein the noble metal alloy includes at least two of the following noble metals: silver, gold, palladium, platinum or the alloy with at least one noble metal content includes silver, gold, palladium and/or platinum as well as nickel and/or carbon as noble metal content.

2. The contacting apparatus according to claim 1, **characterized in that** the alloy with at least one noble metal content is a silver-carbon alloy, in particular AgC1 to AgC6, preferably AgC3.

3. The contacting apparatus according to claim 1, **characterized in that** the alloy with at least one noble metal content is a gold-nickel alloy, in particular AuNi1 to AuNi10, preferably AuNi5.

4. The contacting apparatus according to claim 1, **characterized in that** the noble metal alloy is a gold-palladium alloy, in particular AgPd10 to AgPd60, preferably AgPd40.

5. The contacting apparatus according to any of the preceding claims, **characterized in that** the contact elements (22) are contact wires (23).

6. The contacting apparatus according to claim 5, **characterized in that** the contact wires (23) pass through or are located in apertures (21) of the adapter device (18).

7. The contacting apparatus according to any of the preceding claims 5 or 6, **characterized in that** the contact wires (23) are attached to the adapter device (18) by casting.

8. The contacting apparatus according to any of the preceding claims, **characterized in that** the ends of the contact elements (22) facing away from the test contacts (12) are electrically connected to conductor tracks (28) on a printed circuit board (PCB) (26).

9. The contacting apparatus according to any of the preceding claims, **characterized in that** the noble metal alloy or the alloy with at least one noble metal content is a tempered noble metal alloy or a tempered alloy having at least one noble metal content.

10. The contacting apparatus according to claim 9, **characterized in that** the noble metal alloy or the alloy having at least one noble metal content is a noble metal alloy or the alloy with at least one noble metal content that has been tempered for at least 30 minutes, in particular for at least 60 minutes.

11. The contacting apparatus according to any of the preceding claims 9 or 10, **characterized in that** after the tempering process, the noble metal alloy or the alloy with at least one noble metal content is cooled down to room temperature over a predetermined time period.

12. The contacting apparatus according to claim 11, **characterized in that** the cooling down time period is at least 15 minutes, preferably at least 30 minutes.

13. A method for producing at least one contact element of a contacting apparatus according to one or several of the preceding claims for electrically connecting a unit under test to an electrical test device, wherein the contact elements (22) are manufactured from a noble metal alloy or an alloy with at least one noble metal content, wherein the noble metal alloy includes at least two of the following noble metals: silver, gold, palladium, platinum or the alloy with at least one noble metal content includes silver, gold, palladium and/or platinum as well as nickel and/or carbon as noble metal content.

14. Method according to claim 13, **characterized in that** the noble metal alloy or the alloy with at least one noble metal content is tempered for at least 30 minutes, preferably at least 60 minutes.

15. Method according to claim 14, **characterized in that** the tempering takes place at a temperature of 80°C to 160°C, preferably of 120°C.

16. Method according to any of the preceding claims 14 or 15, **characterized in that** after the tempering a cooling down over a time period of at least 15 minutes, in particular at least 30 minutes, takes place.

17. Method according to claim 16, **characterized in that** the cooling down takes place to room temperature, in particular to 15°C to 25°C, preferably 20°C.

## Revendications

1. Dispositif de mise en contact (1) pour électriquement relier un échantillon (3) avec un dispositif d'essai électrique, avec plusieurs contacts d'essai électriques (12) associés à au moins un élément de retenue (5) pour la mise en contact de l'échantillon (3), et avec un dispositif de déplacement (18) pour agrandir la distance entre trajets de contact adjacents, le dispositif de déplacement (18) comprenant des éléments de contact (22) pour la mise en contact physique des contacts d'essai (12), **caractérisé en ce que** les éléments de contact (22) consistent en un alliage de métaux précieux ou un alliage avec au moins une teneur en métaux précieux, l'alliage de métaux précieux comprenant au moins deux des métaux précieux suivants : argent, or, palladium, platine, ou l'alliage avec au moins une teneur en métaux précieux comprend, en tant que teneur en métaux précieux, de l'argent, or, palladium et/ou platine aussi que du nickel et/ou carbone.

2. Dispositif de mise en contact selon la revendication 1, **caractérisé en ce que** l'alliage avec au moins une teneur en métaux précieux est un alliage argent-carbone, notamment AgC1 à AgC6, de préférence AgC3.

3. Dispositif de mise en contact selon la revendication 1, **caractérisé en ce que** l'alliage avec au moins une teneur en métaux précieux est un alliage or-nickel, notamment AuNi1 à AuNi10, de préférence AuNi5.

4. Dispositif de mise en contact selon la revendication 1, **caractérisé en ce que** l'alliage de métaux précieux est un alliage or-palladium, notamment AgPd10 à AgPd60, de préférence AgPd40.

5. Dispositif de mise en contact selon l'une quelconque des revendications précédentes, **caractérisé en ce que** les éléments de contact (22) sont des fils de contact (23).

6. Dispositif de mise en contact selon la revendication 5, **caractérisé en ce que** les fils de contact (23) passent à travers de, ou sont logés dans ouvertures (21) du dispositif de déplacement (18).

7. Dispositif de mise en contact selon l'une quelconque des revendications précédentes 5 ou 6, **caractérisé en ce que** les fils de contact (23) sont fixés sur le dispositif de déplacement (18) par coulage.

8. Dispositif de mise en contact selon l'une quelconque des revendications précédentes, **caractérisé en ce que** les extrémités des éléments de contact (22) opposées aux contacts d'essai (12) sont électriquement reliés avec des pistes conductrices (28) d'une carte de circuit imprimé (PCB) (26).

9. Dispositif de mise en contact selon l'une quelconque des revendications précédentes, **caractérisé en ce que** l'alliage de métaux précieux ou l'alliage avec au moins une teneur en métaux précieux est un alliage de métaux précieux recuit ou un alliage recuit avec au moins une teneur en métaux précieux.

10. Dispositif de mise en contact selon la revendication 9, **caractérisé en ce que** l'alliage de métaux précieux ou l'alliage avec au moins une teneur en métaux précieux est un alliage de métaux précieux, ou un alliage avec au moins une teneur en métaux précieux, respectivement recuit pendant au moins 30 minutes, notamment au moins 60 minutes.

11. Dispositif de mise en contact selon l'une quelconque des revendications précédentes 9 ou 10, **caractérisé en ce que** l'alliage de métaux précieux ou l'alliage avec au moins une teneur en métaux précieux est refroidi jusqu'à la température ambiante pendant une période prédéterminée après le procédé de recuit.

12. Dispositif de mise en contact selon la revendication 11, **caractérisé en ce que** la période de refroidissement est au moins 15 minutes, de préférence au moins 30 minutes.

13. Procédé pour fabriquer au moins un élément de contact d'un dispositif de mise en contact selon l'une ou plusieurs des revendications précédentes, pour la connexion électrique d'un échantillon avec un dispositif d'essai électrique, dans lequel les éléments de contact (22) sont fabriqués d'un alliage de métaux précieux ou d'un alliage avec au moins une teneur en métaux précieux, l'alliage de métaux précieux comprenant au moins deux des métaux précieux suivants : argent, or, palladium, platine, ou l'alliage avec au moins une teneur en métaux précieux comprend, en tant que teneur en métaux précieux, de l'argent, or, palladium et/ou platine aussi que du nickel et/ou carbone.

14. Procédé selon la revendication 13, **caractérisé en ce que** l'alliage de métaux précieux ou l'alliage avec au moins une teneur en métaux précieux est recuit pendant au moins 30 minutes, de préférence au moins 60 minutes.

15. Procédé selon la revendication 14, **caractérisé en ce que** le recuit est effectué à une température de 80 °C à 160 °C, de préférence à une température de 120 °C.

16. Procédé selon l'une quelconque des revendications précédentes 14 ou 15, **caractérisé en ce que**, après le recuit, un refroidissement est effectué pendant une période d'au moins 15 minutes, notamment au moins 30 minutes.

17. Procédé selon la revendication 16, **caractérisé en ce que** le refroidissement est effectué jusqu'à la température ambiante, notamment jusqu'à 15 °C à 25 °C, de préférence 20 °C.
